# DEMANDE DE BREVET EUROPEEN

(11) **EP 4 722 739 A1**
(43) Date de publication de la demande: **08.04.2026**
(21) Numéro de dépôt: 25201627.4
(22) Date de dépôt: 11.09.2025
(51) Int. Cl.: G01R 19/155, G01R 19/165, G01R 31/08, G01R 31/58, H01R 13/46, H01R 13/717, H01R 13/518, H01R 24/64

(54) **DISPOSITIF D'INDICATION COMBINÉE D ACTIVITÉ ET DE CATÉGORIE D'INTENSITÉ POUR CÂBLE DE TRANSMISSION DE DONNÉES**

(30) Priorité: 03.10.2024 FR 2410644
(71) Demandeur: Aginode Group, 75001 Paris (FR)
(72) Inventeur: AIR BEN ALI, Rachid, 75001 Paris (FR)
(74) Mandataire: Ipsilon

(57) **Abrégé**

Ce dispositif indicateur pour un câble (16) de transmission de données relié à un port de connexion (18) comporte un système (20) de mesure adapté à détecter la présence d'un courant électrique circulant dans le câble (16) et à mesurer l'intensité de ce courant électrique et au moins un élément lumineux (22) connecté au système (20) de mesure, l'état allumé ou éteint de l'au moins un élément lumineux (22) correspondant à l'état actif ou non du port de connexion (18) et la position et/ou la couleur de l'au moins un élément lumineux (22) correspondant à une catégorie à laquelle appartient l'intensité.

## Description

La présente invention se rapporte à un dispositif d'indication combinée d'activité et de catégorie d'intensité pour câble de transmission de données.

L'invention appartient au domaine des accessoires pour câbles électriques. Elle trouve à s'appliquer notamment aux câbles de transmission de données.

L'invention sera décrite ici dans le contexte d'une installation PoE, en anglais « Power over Ethernet », de transmission de puissance superposée aux données dans les réseaux locaux (LAN, en anglais « Local Area Network »). Néanmoins, cet exemple n'est pas limitatif, l'invention s'appliquant dans des contextes différents, au niveau de toute borne de connexion de câble électrique, qu'il s'agisse par exemple d'un panneau de brassage, ou d'une prise électrique, ou encore d'un point de consolidation.

Dans les installation PoE, les armoires de connexion actuelles contiennent généralement des panneaux de brassage rassemblant un grand nombre de câbles de transmission de données.

Un étiquetage permanent peut être présent sur l'avant d'un panneau de brassage pour indiquer la catégorie ou niveau d'intensité du courant des câbles à connecter dans ce panneau de brassage, sous forme d'une indication du type « RPx », où x est un nombre entier de 1 à 3 qui correspond à une catégorie d'intensité de courant.

En cas de remplacement des câbles contenus dans le panneau de brassage par des câbles supportant un niveau d'intensité différent, cet étiquetage devient caduc et peut donc conduire à des erreurs d'affectation de câbles, c'est-à-dire au branchement de câbles supportant une intensité inférieure à celle indiquée sur l'étiquetage.

Par ailleurs, une information sur l'activité présente sur les câbles de transmission de données peut être disponible dans un boîtier séparé des panneaux de brassage, typiquement sous forme de voyants qui s'allument en cas de trafic sur les câbles et qui sont éteints si le trafic est nul.

Avec une information de ce type sur l'activité des câbles, vu le grand nombre de câbles contenus dans l'armoire, il est difficile de déterminer rapidement à quel câble correspond quel trafic.

En outre, l'opérateur ne dispose pas au même endroit d'une information rapidement accessible sur la catégorie d'intensité et sur l'activité des câbles.

La présente invention a pour but de remédier aux inconvénients précités de l'art antérieur.

Dans ce but, la présente invention propose un dispositif indicateur pour un câble de transmission de données relié à un port de connexion, le dispositif étant remarquable en ce qu'il comporte un système de mesure adapté à détecter la présence d'un courant électrique circulant dans le câble et à mesurer l'intensité de ce courant électrique et au moins un élément lumineux connecté au système de mesure, l'état allumé ou éteint de l'au moins un élément lumineux correspondant à l'état actif ou non du port de connexion et la position et/ou la couleur de l'au moins un élément lumineux correspondant à une catégorie à laquelle appartient l'intensité.

Ainsi, la présente invention permet de disposer simultanément, de façon combinée et centralisée, d'une information à jour sur la catégorie à laquelle appartient l'intensité du courant qui circule dans le câble et d'une information sur l'activité actuelle du port de connexion de ce câble. Cela permet en outre, non seulement d'éviter des erreurs de branchement de câbles dont la catégorie d'intensité n'est pas adaptée au port de connexion envisagé, mais en outre d'éviter de déconnecter par inadvertance des câbles reliés à un port de connexion actif.

Dans un mode particulier de réalisation, le système de mesure comporte un collier adapté à se positionner autour du câble.

Cela permet de mesurer de façon non intrusive l'intensité du courant qui circule dans le câble. En outre, le collier peut avoir une fonction additionnelle de moyen de maintien du câble dans son environnement. Le collier peut par exemple servir de support de fixation au câble, par exemple sur un élément d'infrastructure tel qu'un panneau de brassage.

Dans un mode particulier de réalisation, le collier comporte une pince ampèremétrique.

Cela constitue un moyen simple et fiable de mesure de l'intensité du courant circulant dans le câble autour duquel la pince ampèremétrique est disposée.

Dans un mode particulier de réalisation, l'au moins un élément lumineux est une diode électroluminescente.

Ce type d'élément lumineux est peu encombrant et peu coûteux.

Dans un mode particulier de réalisation, le dispositif comporte une pluralité d'éléments lumineux ayant chacun une position et/ou une couleur correspondant à une catégorie à laquelle appartient l'intensité.

En variante, le dispositif comporte un élément lumineux unique dont la couleur varie selon la catégorie à laquelle appartient l'intensité.

Dans un mode particulier de réalisation, le dispositif est compris dans un panneau de brassage.

Dans un mode particulier de réalisation, l'au moins un élément lumineux est situé sur la face avant du panneau de brassage, offrant ainsi à l'opérateur une visualisation particulièrement aisée des informations d'intensité et d'activité.

Dans le même but que celui indiqué plus haut, la présente invention propose également un panneau de brassage, remarquable en ce qu'il comporte un dispositif indicateur tel que succinctement décrit ci-dessus.

Les caractéristiques particulières et les avantages du panneau de brassage étant similaires à ceux du dispositif indicateur, ils ne sont pas répétés ici.

### Brève description des dessins

D'autres aspects et avantages de l'invention apparaîtront à la lecture de la description détaillée ci-après de modes particuliers de réalisation, donnés à titre d'exemples nullement limitatifs, en référence aux dessins annexés, dans lesquels :

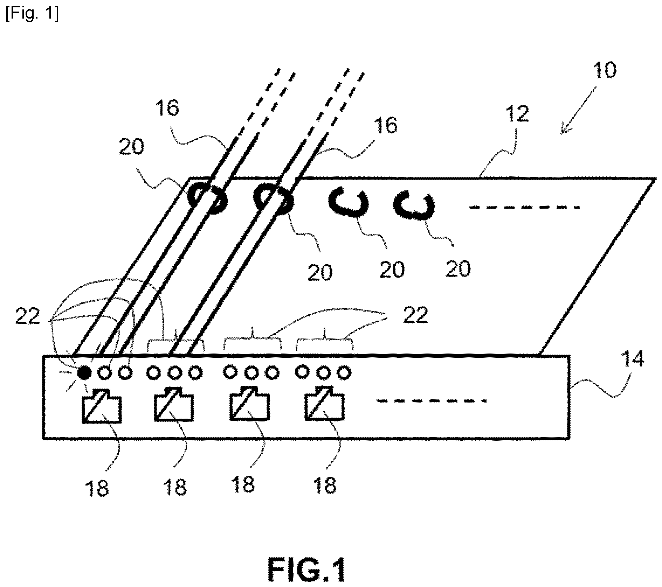

[Fig. 1] est une représentation schématique en perspective d'un panneau de brassage équipé d'un dispositif indicateur conforme à la présente invention, dans un mode particulier de réalisation.

### Description de mode(s) de réalisation

La figure 1 illustre un mode particulier de réalisation d'un dispositif indicateur conforme à la présente invention, dans l'exemple non limitatif où l'invention est utilisée dans un panneau de brassage 10, dont seuls le plateau 12 et la face avant 14 sont représentés. Dans ce mode particulier de réalisation, le dispositif indicateur est compris dans le panneau de brassage 10.

Un ou plusieurs câbles électriques 16 de transmission de données peuvent être disposés sur le plateau 12. Dans l'exemple illustré, deux câbles 16 sont représentés.

Chaque câble 16 est relié à un port de connexion 18. Les ports de connexion 18 sont par exemple des ports de type RJ45 bien connus de l'homme du métier.

Le dispositif indicateur comporte un ou plusieurs systèmes 20 de mesure, chaque système 20 de mesure étant adapté à détecter la présence d'un courant électrique circulant dans un des câbles 16 et à mesurer l'intensité de ce courant électrique.

Dans le mode particulier de réalisation de la figure 1, chaque système 20 de mesure comporte un collier adapté à se positionner autour du câble 16 et comporte une pince ampèremétrique. Si le panneau de brassage 10 comporte vingt-quatre ports de connexion 18, il comporte ainsi vingt-quatre colliers. Chaque collier peut être fixé sur le panneau de brassage 10 et peut se présenter sous la forme de deux demi-anneaux assemblés par une charnière, adaptés à se refermer sur le câble 16, comme le montrent les deux colliers de gauche en position fermée et les deux colliers de droite en position ouverte sur la figure 1. Toutefois, cet exemple de réalisation n'est pas limitatif : le système de mesure peut prendre toute autre forme, comme par exemple un capteur de courant placé sur le câble 16 ou à proximité de celui-ci.

Le dispositif indicateur comporte en outre au moins un élément lumineux 22 connecté au système 20 de mesure. Cette connexion peut être réalisée par exemple par l'intermédiaire d'une carte électronique adaptée à traiter la mesure et à la convertir en information lumineuse.

Conformément à l'invention, l'état allumé ou éteint de l'au moins un élément lumineux 22 correspond à l'état actif ou non du port de connexion 18 et la couleur de l'au moins un élément lumineux 22 correspond à une catégorie à laquelle appartient l'intensité du courant circulant dans le câble 16, par exemple RP1, RP2 ou RP3. Dans l'exemple non limitatif illustré sur la figure 1, l'élément lumineux 22 le plus à gauche est allumé, indiquant que le port de connexion 18 le plus à gauche est actif et que le câble 16 relié à ce port de connexion 18 est traversé par un courant dont l'intensité appartient à une première catégorie, par exemple RP1.

Dans le mode particulier de réalisation de la figure 1, l'au moins un élément lumineux 22 est situé sur la face avant du panneau de brassage 10. Avantageusement, le ou les éléments lumineux 22 rendant compte de l'activité et de l'intensité sur un câble 16 donné sont placés dans la région du panneau de brassage 10 située dans l'alignement de ce câble 16.

L'élément lumineux 22 peut par exemple être une diode électroluminescente. Cet exemple n'est toutefois pas limitatif et l'élément lumineux peut prendre toute autre forme, telle qu'une fibre optique apportant l'information lumineuse en face avant du panneau de brassage 10.

Dans le mode particulier de réalisation illustré, le dispositif indicateur comporte plusieurs éléments lumineux 22 ayant chacun une position et/ou une couleur correspondant à une catégorie à laquelle appartient l'intensité du courant traversant le câble 16. Sur la figure 1, trois éléments lumineux 22 sont placés côte à côte horizontalement en regard de chaque câble 16. Ils pourraient aussi bien être placés côte à côte verticalement. Ils peuvent avoir une même couleur et peuvent correspondre respectivement à la catégorie RP1, à la catégorie RP2 et à la catégorie RP3. En variante, les trois éléments lumineux peuvent avoir chacun une couleur différente, à savoir, une première couleur correspondant à la catégorie RP1 (par exemple vert), une deuxième couleur correspondant à la catégorie RP2 (par exemple bleu) et une troisième couleur correspondant à la catégorie RP3 (par exemple rouge). Dans ces deux modes de réalisation, un marquage redondant avec l'information lumineuse peut être prévu sur le panneau de brassage 10 à côté de chaque élément lumineux 22, pour rappeler la catégorie d'intensité indiquée par la position et/ou la couleur de chaque élément lumineux 22. Ce marquage peut être réalisé directement sur la surface du panneau de brassage 10, ou peut figurer sur une étiquette apposée par tout moyen de fixation sur le panneau de brassage 10.

Dans une autre variante, le dispositif indicateur peut comporter un élément lumineux unique dont la couleur varie selon la catégorie à laquelle appartient l'intensité du courant traversant le câble 16, le code couleur étant par ailleurs connu de l'opérateur ou pouvant être rappelé sur une notice, ou par un marquage sur le panneau de brassage 10.

## Revendications

1. Dispositif indicateur pour un câble (16) de transmission de données relié à un port de connexion (18), ledit dispositif étant **caractérisé en ce qu'**il comporte un système (20) de mesure adapté à détecter la présence d'un courant électrique circulant dans ledit câble (16) et à mesurer l'intensité dudit courant électrique et au moins un élément lumineux connecté (22) audit système (20) de mesure, l'état allumé ou éteint dudit au moins un élément lumineux (22) correspondant à l'état actif ou non dudit port de connexion (18) et la position et/ou la couleur dudit au moins un élément lumineux (22) correspondant à une catégorie à laquelle appartient ladite intensité.

2. Dispositif selon la revendication 1, **caractérisé en ce que** ledit système (20) de mesure comporte un collier adapté à se positionner autour dudit câble (16).

3. Dispositif selon la revendication 2, **caractérisé en ce que** ledit collier comporte une pince ampèremétrique.

4. Dispositif selon la revendication 1, 2 ou 3, **caractérisé en ce que** ledit au moins un élément lumineux (22) est une diode électroluminescente.

5. Dispositif selon l'une quelconque des revendications précédentes, **caractérisé en ce qu'**il comporte une pluralité d'éléments lumineux (22) ayant chacun une position et/ou une couleur correspondant à une catégorie à laquelle appartient ladite intensité.

6. Dispositif selon l'une quelconque des revendications 1 à 4, **caractérisé en ce qu'**il comporte un élément lumineux (22) unique dont la couleur varie selon la catégorie à laquelle appartient ladite intensité.

7. Dispositif selon l'une quelconque des revendications précédentes, **caractérisé en ce qu'**il est compris dans un panneau de brassage (10).

8. Dispositif selon la revendication précédente, **caractérisé en ce que** ledit au moins un élément lumineux (22) est situé sur la face (14) avant du panneau de brassage (10).

9. Panneau de brassage (10), **caractérisé en ce qu'**il comporte un dispositif indicateur selon l'une quelconque des revendications précédentes.
